# DEMANDE DE BREVET EUROPEEN

(11) **EP 4 661 067 A1**
(43) Date de publication de la demande: **10.12.2025**
(21) Numéro de dépôt: 25180592.5
(22) Date de dépôt: 03.06.2025
(51) Int. Cl.: H01L 21/78, H01L 21/02, H10H 20/01

(54) **PROCÉDÉ POUR DÉCOLLER UNE COUCHE ÉPITAXIÉE DE SON SUBSTRAT DE CROISSANCE PAR PRÉ-ABLATION LASER DE LA COUCHE TAMPON SACRIFICIELLE**

(30) Priorité: 03.06.2024 FR 2405798
(71) Demandeur: Rogers, David J., 10300 Sainte Savine (FR); Hosseini-Teherani, Ferechteh, 91400 Orsay (FR); Sandana, Vinod E., 95140 Garges les Gonesse (FR)
(72) Inventeur: Rogers, David J., 10300 Sainte Savine (FR); Hosseini-Teherani, Ferechteh, 91400 Orsay (FR); Sandana, Vinod E., 95140 Garges les Gonesse (FR)
(74) Mandataire: Setayesh Bamas, Sousan

(57) **Abrégé**

L'invention décrit un procédé hybride de décollage de couches épitaxiées d'un substrat de croissance recouvert d'une couche tampon sacrificielle. Ce procédé combine une ablation laser initiale, qui affaiblit la liaison entre la couche tampon et le substrat, et une attaque chimique préférentielle (ELO) pour dissoudre la couche tampon. Cette approche accélère le décollage sans endommager la face arrière des couches épitaxiées, permettant un transfert intact. Le processus s'applique à des sur-couches ou des empilements épitaxiés de matériaux semi-conducteurs utilisés dans des composants électroniques. Ces derniers, une fois décollés et transférés sur un substrat conducteur, trouvent des applications dans l'électronique de puissance, notamment pour des dispositifs comme les diodes électroluminescentes (LED) et les transistors. Cette méthode innovante assure une efficacité accrue et préserve l'intégrité des matériaux semi-conducteurs, répondant aux exigences des technologies à haute densité de puissance.

## Description

### DOMAINE TECHNIQUE DE L'INVENTION

Le domaine de l'invention est relatif aux matériaux sous forme de couches cristallines épitaxiées et leurs reports d'un substrat de croissance vers un substrat d'accueil avec des propriétés et/ou un coût plus apte(s) pour une application visée que le substrat de croissance. Ceci est le cas pour les couches actives dans divers dispositifs électroniques et opto-électroniques dédiés à de forte densité de puissance par unité de surface (tel que l'électronique de puissance, l'électronique transparent, le piézoélectrique, les LEDs, les lasers).

En effet, le substrat de croissance utilisé lors d'un dépôt par épitaxie est constitué typiquement d'un monocristal massif choisi afin de privilégier une structure et orientation cristalline qui est reproduite par les films épitaxiés dessus. Souvent le choix de substrat de croissance est très limité et le substrat ne peut offrir l'ensemble des propriétés qui sont souhaitables pour l'application finale (par exemple souplesse, transparence, conductivité (électrique et/ou thermique) etc.

Par exemple, dans l'électronique de puissance (l'application de l'électronique à semi-conducteurs pour le contrôle, la commutation et la conversion de l'énergie électrique à haute tension ou puissance) les composants (e.g. le transistor à effet de champ, la jonction p-n, ou le Schottky Barrier Diode (SBD)) souffrent d'auto-échauffement en raison de la conductivité thermique relativement faible des substrats de croissance typiquement utilisés (par exemple le Ga2O3 sur le saphir). Les effets néfastes de cette faible conductivité thermique sur la performance et la durée de vie de ces composants sont désormais reconnus et des solutions doivent être trouvées pour résoudre ce problème.

Actuellement, l'électronique de puissance souffre d'une relativement faible efficacité énergétique ainsi que d'une forte limitation dans la gestion des puissances/tensions maximales utilisées par rapport à celles intrinsèquement disponibles. L'amélioration de ces deux aspects est actuellement considérée comme un verrou technologique sur la route d'une transmission et d'une conversion efficace de l'énergie électrique à faible émission de carbone.

Le silicium (Si) est actuellement le matériau électronique le plus répandu dans l'électronique de puissance. Néanmoins, l'électronique au silicium est confrontée à un défi dans l'application de l'électronique de puissance : les performances des appareils à base de Si se dégradent fortement à des températures élevées, limitant leur utilisation dans l'électronique à haute puissance à grande densité ( i.e par unité de surface).De plus, le Silicium étant un matériau à bande interdite faible et indirecte, le silicium a un champ électrique de claquage relativement bas. Ceci implique que les possibilités de gestion de la haute puissance/tension sont limitées. Comme alternative au Si, il existe une nouvelle génération de semi-conducteurs à large bande interdite qui ont la capacité de fonctionner à des tensions, des températures et des fréquences de commutation plus élevées et avec des rendements supérieurs à ceux des dispositifs en Si. Leurs propriétés entraînent non seulement moins de pertes, mais elles permettent également des dispositifs avec une volume considérablement réduit, en raison des exigences de refroidissement réduites, contribuant, également, à un coût global du système plus faible.

Pour la pleine réalisation du potentiel de ces composants, cependant, il est nécessaire que la croissance des matériaux semiconducteurs à large bande interdite puisse être réalisée sur des substrats capables de favoriser l'évacuation la chaleur générée par les pertes dissipées.

En effet, les composants à base de matériaux semiconducteurs à large bande interdites épitaxiés sur des substrats de croissance isolants ne conviennent pas à une utilisation dans l'électronique de puissance sans un dispositif de refroidissement à cause de la chaleur qui accumule et détériore la performance du composant. Donc il est souhaitable de transférer les couches semiconductrices directement sur des dissipateurs thermiques mais les substrats de croissance disponibles actuellement ne proposent pas la possibilité d'avoir, à la fois, une bonne qualité d'épitaxie et une bonne conductivité thermique. Pour cela, il est nécessaire de reporter les couches actives épitaxiées à partir de leurs substrats de croissance isolants vers des substrats d'accueil qui ont une plus grande conductivité thermique.

### ETAT DE LA TECHNIQUE ANTERIEUR

Actuellement il existe plusieurs techniques pour l'enlèvement d'une couche épitaxiée de son substrat de croissance (ref - Figure). Toutes ces techniques ont leurs atouts et leurs inconvénients.

Les documents de l'état de l'art montre comment séparer une couche épitaxiée de GaN de son substrat de croissance isolant (en saphir) par une ablation laser à travers le substrat («un procédé qui s'appelle « Laser Lift-Off » (LLO)). Un problème significatif avec ce procédé de décollage est que la face arrière de GaN obtenue est endommagée et rugueuse, avec des restes/particules de gallium métallique sur la surface. Les propriétés de GaN dans la région endommagé sont dégradées, donc c'est difficile (mécaniquement) de coller cette face rugueuse sur un substrat d'accueil avec une surface lisse. Ce qui nuit au couplage optique, thermique et électronique avec le substrat d'accueil.

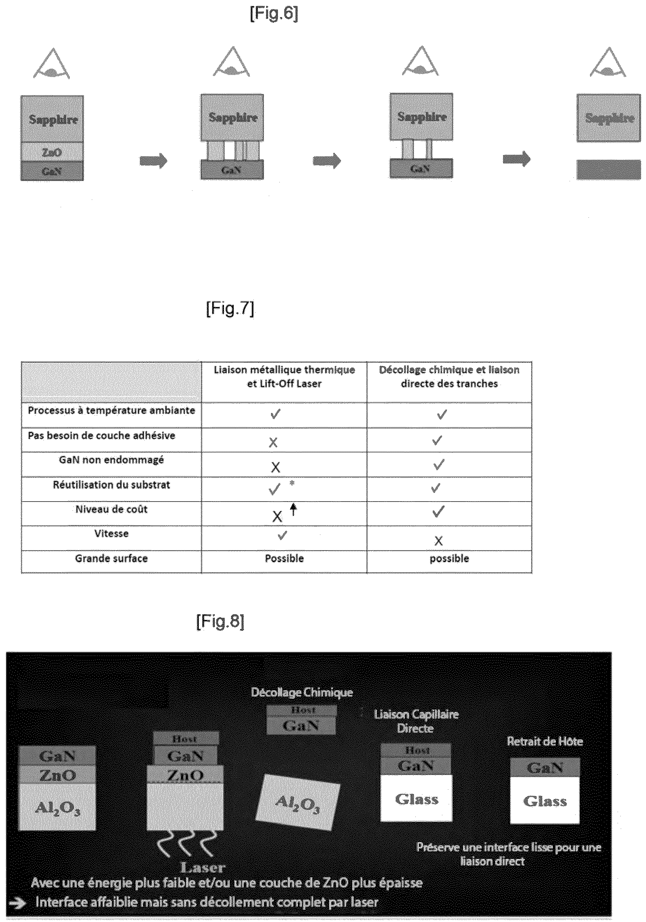

Une autre solution proposée est le ELO (décollage par gravure chimique préférentielle d'une sous couche sacrificielle) - voir Figure 6. Le procédé consiste en une dissolution chimique d'une sous-couche (tampon) sacrificielle épitaxiée sur le substrat de saphir, sur laquelle une sur-couche épitaxiée est déposée. Le lift off chimique dissout totalement la couche tampon sacrificielle et ainsi la couche épitaxiée se sépare du substrat de croissance. Contrairement à un lift-off laser, la face arrière de la sur-couche épitaxiée n'est pas endommagée et ainsi on obtient une surface parfaite, lisse et sans défaut pouvant être transférée sur un substrat conducteur avec un bon couplage mécanique, optique, électrique et thermique.

Deux problèmes significatifs avec le procédé d'ELO : i) la gravure chimique ralentie progressivement et, ii) le temps nécessaire pour la gravure chimique augmente significativement quand la surface du wafer augmente. En effet, le procédé de décollage par ELO peut prendre plusieurs heures, voire plusieurs jours. Or une telle vitesse de procédé n'est pas bien adaptée pour des fabrications industrielles.

Il est donc souhaitable d'avoir un procédé de décollage qui puisse, à la fois, ne pas endommager la face arrière de la couche épitaxiée et être suffisamment rapide pour une utilisation ou fabrication industrielle.

L'objet de la présente invention est de réaliser un décollage rapide d'un matériau épitaxiée de son substrat de croissance, tel que la surface du matériau décollé ne soit pas endommagée et que le coût de processus de décollage ne soit pas élevé pour qu'il puisse convenir à la fabrication industrielle.

### EXPOSE DE L'INVENTION

L'invention consiste en un procédé hybride entre le LLO et le ELO pour accélérer le décollage. Pour cela l'invention propose un procédé pour décoller une sur-couche ou un empilement de sur-couches épitaxiées d'un substrat de croissance recouverte d'une couche tampon sacrificielle, cette couche sacrificielle se situant entre ledit substrat de croissance et la couche épitaxiée. Le procédé est caractérisé en ce qu'il comprend une première étape d'ablation par laser de la base de la couche tampon sacrificielle, suivi d'une deuxième étape par une attaque chimique préférentielle de ladite couche tampon sacrificielle (appelé ELO) de sorte que l'ablation par laser affaiblit la liaison entre la sous-couche sacrificielle et le substrat de croissance avant l'attaque chimique pour accélérer la subséquente dissolution de la sous-couche et le décollage de la ou les sur-couche(s) épitaxiée(s) du substrat de croissance sans endommager la face arrière de la couche épitaxiée.

En outre, dans le procédé de décollage ci-dessus, le substrat de croissance est du saphir et la fragilisation de la base de la couche sacrificielle par ablation laser est fait à travers la face arrière, la face sans dépôt, du substrat.

De plus, suivant la nature de la couche tampon sacrificielle, l'ablation par laser peut être réalisée par accumulation de tirs laser couvrant l'entière surface du substrat de saphir, ou par le balayage d'un faisceau laser mis en forme de façon optique pour obtenir la géométrie adéquate et homogène nécessaire à l'ablation laser.

Par ailleurs, après la mise en forme optique d'un faisceau laser, l'ablation par laser est effectuée sous n'importe quelle angle d'incidence entre 0 et 90, perpendiculaire à la surface du substrat jusqu'à la transversale du substrat sur une tranche, en focalisant l'énergie sur la sous-couche tampon sacrificielle de sorte à fragiliser la base de la sous-couche sacrificielle. En outre, l'ablation par laser peut être associé à un mouvement circulaire et/ou transversal du substrat pour une plus grande homogénéité d'excitation sur des substrats de grands dimensions.

De préférence, la sur-couche épitaxiée est du GaN ou du SiC ou du Ga203 (α, β, γ δ ou κ), et la sous-couche tampon sacrificielle peut être en ZnO, ou en CrN ou en SiO₂, l'épaisseur de ladite sous-couche tampon sacrificielle est comprise entre 0,5 nm et 100 micron.

L'invention comprend également, un composant à semiconducteur comprenant une couche épitaxiée de matériau semiconducteur tel que du GaN ou du Ga2O3 (α, β, γ δ ou κ) ou du SiC avec une surface lisse décollée de son substrat de saphir selon le procédé ci-dessus. La couche de matériau semiconducteur décollée étant transférée sur un substrat d'accueil conducteur. Ledit substrat d'accueil est tel qu'il ait un facteur de dissipation de chaleur le plus forte possible possédant des caractéristiques optiques, électriques et thermiques pour les dispositifs de l'électronique de puissance tel que le SiC ou un diamond ou un métal.

L'invention concerne en outre l'utilisation du composant à semiconducteur ci-dessus dans l'électronique de puissance ou dans des dispositifs tels que des diodes électroluminescentes ou des transistors.

### BREVE DESCRIPTION DES FIGURES

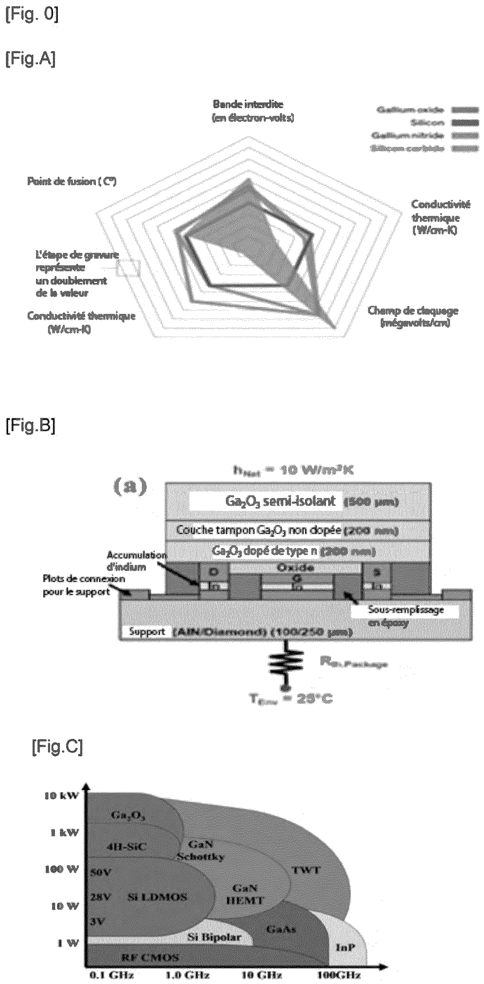

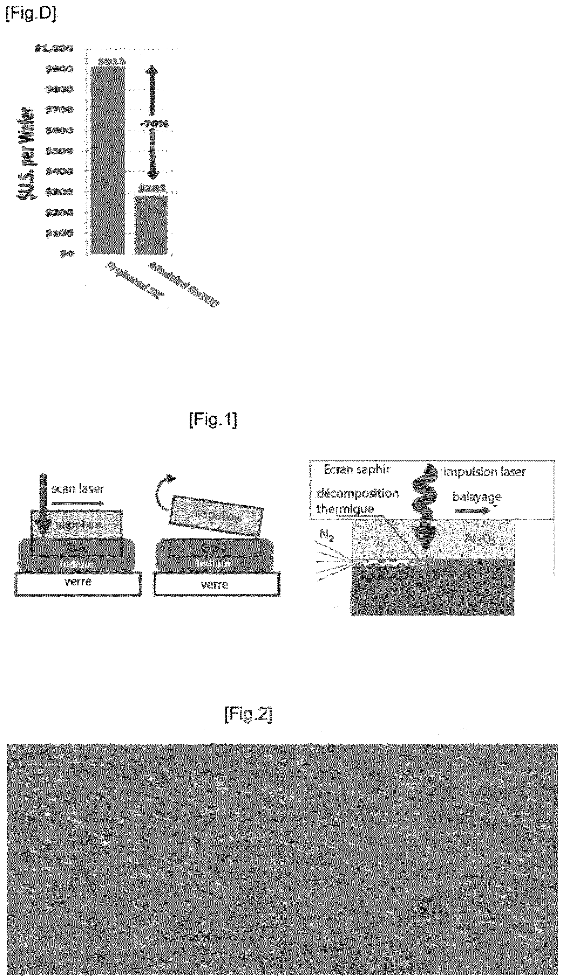

[fig.0] constitué de quatre figures, montre une cartographie des perspectives d'accumulation sur les principaux avantages et inconvénients comparatifs des principaux semi-conducteurs utilisés comme base de l'électronique de puissance ; [fig.A] un graphique contrastant les propriétés des matériaux clés β-Ga2O3 avec celles des matériaux d'électronique de puissance actuels; [fig.B] illustration d'une configuration de puce retournée utilisée pour relier un dispositif d'alimentation en Ga203 à un dissipateur thermique [191] ; [fig.C] une cartographie des technologies considérées comme techniquement supérieures dans l'espace puissance/fréquence [139] ; [fig.D] une comparaison des coûts projetés pour la fabrication de dispositifs électriques à base de sic et de β-Ga2O3 [192] ;
[Fig.1] représente le processus de décollage (lift off) au laser (LLO) d'une couche épitaxiée de Ga2O3 d'un substrat de croissance en saphir ;
[Fig.2] illustre la surface de la face arrière de la couche de Ga203 obtenue après le décollage LLO ;
[Fig.3] illustre une couche de Ga2O3 épitaxiée sur un substrat de saphir recouverte d'une couche tampon sacrificielle (ZnO) ;
[Fig. 4] illustre le processus de décollage (lift off) chimique (ELO) d'une couche épitaxiée de Ga2O3 d'un substrat de saphir recouverte d'une couche tampon sacrificielle (ZnO) ;
[Fig. 5A et Fig. 5B] présentent une coupe axiale illustrant la continuité de l'interface et la surface lisse de la sur-couche épitaxiée en Ga2O3 et la sous-couche en ZnO avant le décollage;
[Fig.6] illustre le processus de dissolution progressif par ELO de la sous-couche tampon sacrificielle en ZnO;
[Fig.7] illustre un tableau comparatif des caractéristiques de chacune des approches de décollage ci-dessus (décollage au laser (LLO) et décollage par attaque chimique (ELO));
[Fig.8] illustre le processus de décollage hybride d'une sur-couche épitaxiée en Ga2O3 du substrat de saphir recouverte d'une couche tampon sacrificielle (ZnO) selon la présente invention ;

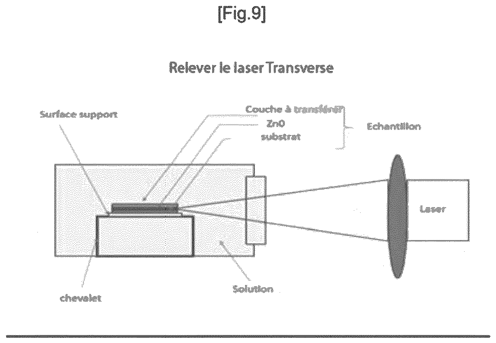

[Fig.9] illustre la technique de décollage d'une couche active de son substart par l'ablation laser transversal sur la sous couche sacrificielle.

### DESCRIPTION DETAILLEE

La figure 0 montre une cartographie d'une perspective actuelle sur les principaux avantages et inconvénients comparatifs des principaux semi-conducteurs utilisés comme base de l'électronique de puissance.

La figure A est un graphique contrastant les propriétés clés des matériaux β-Ga203 avec celles des matériaux d'électronique de puissance actuels. Ce graphique montre clairement que même si Ga2O3 domine en termes d'énergie de bande interdite et de champ de décomposition, il présente des inconvénients très importants en termes de mobilité électronique et de conductivité thermique.

Le deuxième problème est que la gestion thermique, constitue un défi majeur pour le Ga2O3, car la conductivité thermique du substrat en vrac est inférieure d'un ordre de grandeur à celle du saphir, même. Par conséquent, la chaleur s'accumule lors d'un fonctionnement à haute tension et entraîne une dérive des performances et un vieillissement accéléré. Plusieurs solutions potentielles ont été proposées, telles que la croissance épitaxiale directe sur un substrat à conductivité thermique plus élevée (comme le SiC ou le diamant) ou l'intégration du Ga203 avec un dissipateur thermique soit par une approche flip chip (voir ci-dessous), soit en amincissant le substrat Ga2O3 et la plaquette. liaison à un dissipateur thermique [184 - 191].

La figure B est l'illustration d'une configuration de puce retournée utilisée pour lier un dispositif d'alimentation Ga2O3 à un dissipateur thermique [191]. En supposant que ces problèmes de mobilité et de gestion thermique puissent être résolus, Mastro et al. [139] prédisent que les dispositifs de puissance à base de β-Ga2O3 pourraient trouver un avantage concurrentiel dans l'espace de puissance plus élevée et de fréquence plus basse du marché global :

La figure C est une cartographie des technologies considérées comme techniquement supérieures dans l'espace puissance/fréquence [139]. Cela dépendra néanmoins de la capacité du β-Ga2O3 à rivaliser en termes de coûts avec le SiC. Des études de marché récentes suggèrent que le β-Ga2O3 pourrait bien offrir un avantage significatif en termes de coût de fabrication par rapport au SiC à l'avenir [192] (les dispositifs d'alimentation en SiC sont actuellement moins chers que les dispositifs d'alimentation à base de GaN).

La figure D est une comparaison des coûts projetés pour la fabrication de dispositifs électriques à base de SiC et de β-Ga2O3 [192]. Ceci repose en grande partie sur le fait que les substrats monocristallins de β-Ga2O3 peuvent être fabriqués dans un format relativement grand par des procédés de croissance en fusion peu coûteux [136 -138]. Cependant, pour le moment, les substrats β-Ga2O3 coûtent près de deux ordres de grandeur de plus que les substrats saphir équivalents et ils ne sont pas encore disponibles en volumes de production (la base de fabrication actuelle est très petite car dépend exclusivement d'un marché de R&D limité).

Il existe donc un intérêt et des travaux importants consacrés à l'épitaxie du β-Ga203 sur des substrats saphir et, comme ce fut le cas dans le développement des LED GaN, l'amélioration de la qualité épitaxiale du β-Ga2O3 sur le saphir a dépassé les attentes. Il a été compris que le saphir apporte plusieurs avantages (autres que le coût et la disponibilité industrielle en grands formats/volumes) qui pourraient lui permettre de trouver une place dans les futurs portefeuilles de produits d'électronique de puissance β-Ga2O3. Tout d'abord, le saphir a un ordre de grandeur meilleur conductivité thermique que les substrats β-Ga2O3, ce qui permet une meilleure gestion intrinsèque de la chaleur. Ensuite, le décalage épitaxial avec le saphir permet une ingénierie de déformation qui peut améliorer le potentiel de dopage, stabiliser différentes phases/poly-types/orientations/hors équilibre et étendre la gamme d'ingénierie de bande interdite .

De plus, le β-Ga2O3 peut être facilement transféré du saphir sur un autre substrat au moyen d'un décollement laser. Cette approche utilise un faisceau laser tiré à travers le substrat saphir afin d'abler l'interface Ga2O3/saphir et ainsi libérer l'épicouche du substrat (impossible avec les substrats Ga2O3). Une telle approche est largement utilisée pour la fabrication de LED GaN haute luminosité et apporte plusieurs avantages, notamment une meilleure évacuation de la chaleur (le nouveau substrat hôte peut être un dissipateur thermique) et la possibilité de rétrocontacter le β-Ga2O3, ce qui pourrait permettre un flux de courant vertical dans le dispositif et facilitent ainsi des courants plus élevés (en raison de moins d'encombrement de courant et de moins d'échauffement local par rapport aux dispositifs à flux de courant latéral), des architectures de dispositifs plus simples et des empreintes de dispositif plus petites (c'est-à-dire plus de dispositifs par tranche et donc moins de courant).

Tel que représenté sur la Fig.1, selon l'état de technique, une couche de Ga2O3 a été épitaxiée directement sur un substrat de saphir. Le processus de décollage (ou lift off) au laser (LLO) a été utilisé pour décoller le matériau semiconducteur Ga2O3 de son substrat de saphir afin d'être transférée sur un substrat conducteur.

Fig.2 représente la face arrière de la couche de Ga203 après décollage par LLO du substrat en saphir. Le décollage LLO est relativement rapide, mais la face arrière d'une telle couche de Ga2O3 ainsi décollée présent une surface rugueuse et contaminé par la présence de résidus métalliques en gallium. Ceci ne convient pas au transfert/couplage direct du matériau semiconducteur avec un substrat d'accueil conducteur.

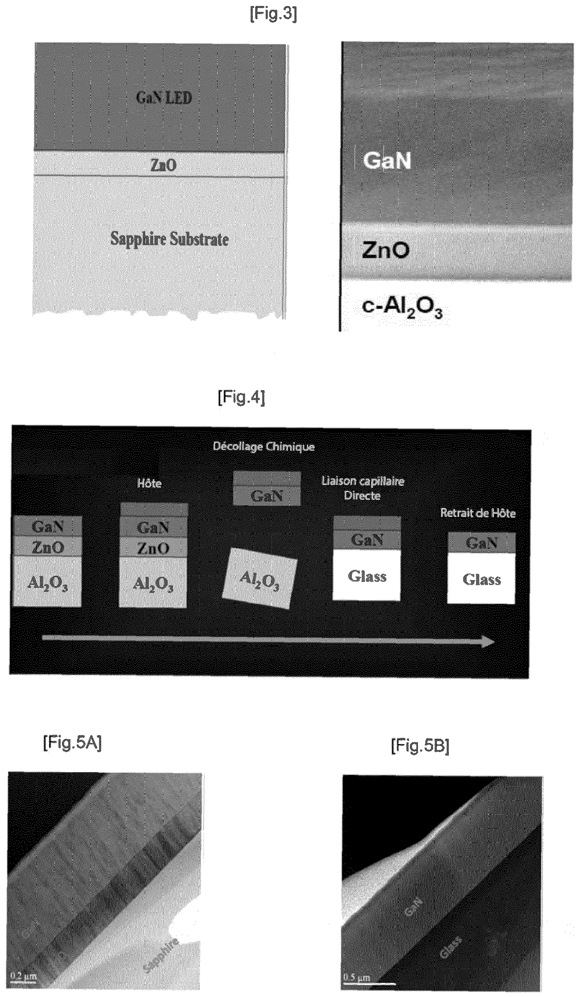

Fig.3 représente une couche épitaxiée en Ga2O3 déposée sur un substrat de saphir recouverte d'une couche tampon en ZnO. L'image représentative montre la continuité de l'interface et les surfaces lisses des deux matériaux.

Fig.4 illustre le processus de décollage de la couche de Ga2O3 du substrat de saphir. Tout d'abord, l'attaque chimique dessoude progressivement la sous-couche sacrificielle située entre le Ga2O3 et le substrat en saphir. Une fois la couche ZnO (sacrificielle) est entièrement éliminée, la sur-couche de Ga2O3 se décolle du substrat. La coupe axiale des Fig.5A et Fig.5B illustrent la continuité de l'interface et de la surface lisse du matériau de Ga2O3 et de ZnO avant le décollage (Fig.5A) et une fois que la couche active en Ga203 est transféré sur un substrat d'accueil (Fig. 5B). L'avantage du ELO ou attaque chimique est qu'il est réalisé à la température ambiante et que la surface arrière de la couche décollé est très lisse, de sorte qu'elle puisse ainsi adhérer plus facilement à un substrat d'accueil, avec un bon couplage mécanique, optique, électrique, thermique, et sans aucun colle/matériau de liaison.

Fig.6 illustre les étapes progressives d' ELO. On remarque que le processus d'ELO est tellement lente qu'il peut prendre plusieurs heures, voire plusieurs jours, or un tel processus malgré ses avantages ne convient pas à une fabrication industrielle en masse.

Le tableau comparatif de la Fig.7 illustre les avantages et les inconvénients des deux approches de décollage LLO et ELO. On remarque sur le tableau que l'avantage particulier de l'approche par laser est la vitesse de décollage, mais il montre également que c'est une approche qui a un cout très élevé et qu'après le décollage la base de la couche de Ga2O3 est endommagé/rugueuse et les résidus métalliques, en gallium, restent sur la couche de matériau semiconducteur Ga2O3.

Fig. 8 représente le processus d'un décollage hybride (pré-ablation suivi d'ELO) d'une sur-couche épitaxiée de Ga2O3 de son substrat de croissance (saphir) recouverte d'une couche tampon sacrificielle (ZnO) selon la présente invention. En effet, le processus hybride consiste en une première étape de fragilisation de la base de la couche tampon par pré-ablation laser suivie dans une deuxième étape d'un décollage ELO (attaque chimique) accéléré. Tel que représenté sur la Fig.8, on réalise l'insolation laser à travers la face arrière du substrat de croissance (face sans dépôt). L'ablation au laser affaiblit la liaison entre la couche sacrificielle et la sur-couche epitaxiée. Suite à la pré-ablation laser, un rapport type ELO est réalisé avec une subséquente attaque chimique accéléré qui dissoute plus rapidement la couche tampon sacrificielle et permet de décoller entièrement la couche de Ga2O3 du substrat de saphir en un temps réduit. La couche ainsi décollée n'est pas endommagé par le laser et n'a pas à sa surface les résidus métalliques en gallium (l'ablation laser étant absorbé par la couche tampon en ZnO) et présente ainsi une surface lisse, qui est mieux adapté à un collage sur un substrat d'accueil, i.e. par exemple un substrat avec une indice de dissipation thermique le plus forte possible pour le cas des dispositifs de l'électronique de puissance.

Dans ce processus hybride de décollage de la couche active, sur-couche épitaxiée, l'ablation laser est réalisée au travers de la face arrière du substrat (face sans dépôt). Cette insolation peut être (suivant la nature de la sur-couche épitaxiée à transférer et/ou de la sous-couche sacrificielle) être réalisée par accumulation de tirs laser couvrant l'entière surface du substrat, ou par balayage d'un faisceau laser mis en forme de façon optique pour obtenir la géométrie adéquate et homogène nécessaire à l'ablation laser de la base de la couche tampon. Ce procédé facilite la dissolution de la couche sacrificielle sans catalyseur liquide ou gazeux.

L'approche de décollage hybride de la présente invention, consiste en une pré-ablation par laser de la base de la couche tampon sacrificielle, suivi d'une attaque chimique préférentielle (ELO) de ladite couche tampon. En effet, l'attaque au laser de la base de la sous-couche tampon sacrificielle affaiblit la liaison entre le substrat de saphir et la couche tampon, de cette manière, la subséquente attaque chimique peut dissoudre plus rapidement la couche sacrificielle et ainsi séparer la couche active de matériau semiconducteur du substrat de saphir. Cette approche de décollage hybride, ne nécessite pas des heures ou des jours pour dissoudre la couche sacrificielle. La surface de la face arrière de la couche ainsi rapporté est lisse et peut adhérer plus facilement à un substrat d'accueil. La rapidité de ce processus de décollage, lui donne l'avantage de mieux convenir à la fabrication industrielle des matériaux semiconducteurs.

Approche de décollage selon la présente invention est une approche conjugué ou hybride, elle est plus rapide qu'une ELO classique et donne une face arrière de la couche épitaxiée détachée sans le dommage et sans les résidus métalliques qui sont caractéristique du LLO. Avec cette surface lisse, la ou les sur-couche(s) épitaxiée(s) décollée(s) est(sont) mieux adapté à un collage direct sur un substrat conducteur.

A noter que le procédé de décollage hybride n'est pas limitatif au couche épitaxie des semiconducteurs tel que le Ga2O3, le GaN ou le SiC. Il peut être appliqué pour décoller des couches épitaxiées piézoélectriques ou autres. La couche sacrificielle utilisée dans ce procédé n'est pas limité au ZnO, non plus, ainsi la couche sacrificielle peut être du CrN ou du SiO₂. L'épaisseur de ladite couche sacrificielle peut être comprise entre 0,5 nm et 100 micron.

L'invention concerne également des composants à semiconducteurs comprenant une couche de matériau semiconducteur avec une surface lisse tel que du GaN ou du SiC ou du Ga203, décollée de leur substrat, sur lequel ils ont été épitaxié et transféré après le décollage sur un substrat conducteur (thermiquement et/ou électriquement). Le substrat sur lequel la ou (les) couche(s) de matériau semiconducteur est transféré a un facteur de dissipation de chaleur le plus forte possible.

L'invention concerne l'utilisation du composant à semiconduteur ci-dessus dans l'électronique de puissance, l'électronique haute fréquence, l'électronique piezo et dans des dispositifs tels que des diodes éléctroluminescentes, les lasers ou des transisteurs.

### DESCRIPTION DE QUELQUES MODES DE REALISATION

Nous allons décrire ci-après un exemple de procédé de réalisation de la présente invention avec l'ensemble de ses étapes.
1) Première étape : Dépôt d'une couche tampon sacrificielle en ZnO sur un substrat monocristallin de saphir.

On peut envisager différentes techniques pour effectuer cette étape :
1.1 : Dépôt par évaporation (par exemple, en utilisant l'épitaxie par jets moléculaires (Molecular Beam Epitaxy, MBE), on utilise une source solide de Zn et un flux de O3 et/ou une source RF plasma de O2.
1.2 : Dépôt par épitaxie en phase vapeur organométallique ou « MetalOrganic Chemical Vapor Deposition, MOCVD ». Cette technique peut utiliser comme précuseurs organométaliques le diethylzinc (DEZn) pour le Zn et l'iso-propanol (*i-*PrOH) et/ou butanol (t-BuOH) pour le O.
1.3 : Dépôt par PLD, typiquement avec un laser excimerKrF et une souce solide ((ou cible) de poudre ZnO (comprimé et fritté) combiné avec l'introduction de oxygène moléculaire dans le chambre de dépôt. Grâce à l'énergie élevée du plasma, la PLD permet d'opérer sous des températures plus basses que les procédés classiques de MBE ou MOCVD ou MOVPE ou HVPE ou pulvérisation.
1.4 Dépôt par épitaxie en phase vapeur organométallique ou « Metal Organic Vapor Phase Epitaxie ».
1.5 Dépôt par pulvérisation.

Ainsi, avec de telles techniques et à partir d'un substrat monocristallin maintenu à une température de quelques centaines de degrés Celsius pendant le dépôt, on procède dans un premier temps au dépôt d'une sous couche tampon sacrificielle en ZnO sur ledit substrat monocristallin de saphir.

2) Seconde étape : Dépôt d'une sur-couche épitaxiée de Ga2O3 sur la sous-couche en ZnO : On peut envisager différentes techniques pour effectuer cette étape :
2.1 : Dépôt par jets moléculaires ou « Molecular Beam Epitaxy, MBE» on utilise des sources solides ou gazeuses des éléments III et un flux de O2 ou O3 et/ou une source et/ou une source de vapeur d'eau et/ou une source RF plasma de 02.
2.2 : Dépôt par épitaxie en phase vapeur organométallique ou « MetalOrganic Chemical Vapeur Deposition, MOCVD ». Cette technique peut utiliser comme précurseurs organométalliques le triméthylgallium (TMGa) pour le Ga. L'azote au lieu d'hydrogène peut être utilisé comme gaz porteur (l'approche conventionnelle).
2.3 : Dépôt par PLD, typiquement avec un laser excimerKrF et une source solide (ou cible) de poudre de GaO3 (comprimé et fritté) combiné avec une source d'O2 ou une RF plasma de O2. Grâce à l'énergie élevée du plasma, la PLD permet d'opérer sous des températures plus basses que les procédés classiques de MBE ou MOCVD ou MOVPE ou HVPE ou pulvérisation.
2.4 Dépôt par épitaxie en phase vapeur organométallique ou « Metal OrganicVapor Phase Epitaxie, MOVPE » Cette technique peut utiliser comme précurseurs organométalliques le triméthylgallium (TMGa) pour le Ga. L'O2 le O3, le H2O et/ou une source RF plasma de O2 peut être utilisé comme source d'oxygène.
2.5 Dépôt par pulvérisation,
2.6 Dépôt par épitaxie en phase vapeur d'hydride ou « HVPE,

3) Libération de la couche épitaxiée de GaO3 du substrat monocristallin en saphir.

On fragilise d'abord la base de la sous-couche tampon en ZnO par une pré-ablation laser (avec un laser excimer, KrF (248nm)) et ensuite on dessoude ladite couche tampon sacrificielle entièrement par attaque chimique à l'acide (eg HCl 0.1M) ou à l'alcalin (eg NaOH 0.1M) sans altérer le substrat de référence ou le revêtement épitaxial de Ga2O3.

Ceci est accompli à travers un décollage par gravure chimique préférentiel (appelé Epitaxial Lift-Off ou « ELO ») d'une sous couche (couche tampon) sacrificielle qui est interposé entre la sur-couche épitaxiée et le substrat de croissance. Un problème significatif avec le procédé d'ELO est que la vitesse de la gravure chimique de la sous-couche sacrificielle augmente (et a tendance à ralentir) quand la surface du wafer agrandie. En effet, le procédé de décollage par ELO peut prendre plusieurs heures, voire plusieurs jours. Une telle vitesse de procédé n'est pas bien adaptée pour des fabrications industrielles. Plus particulièrement, l'invention a pour objet un procédé pour accélérer la vitesse du processus ELO par une pré-ablation laser (à travers le substrat) de la base de la couche tampon et l'utilisation de ce procédé dans des divers domaines technologiques.

## Revendications

1. Procédé pour décoller une sur-couche ou un empilement de sur-couches épitaxiées d'un substrat de croissance recouverte d'une couche tampon sacrificielle, cette couche sacrificielle se situant entre ledit substrat de croissance et la couche épitaxiée, **caractérisé en ce que** pour décoller la couche épitaxiée du substrat de croissance le procédé comprend une première étape d'ablation par laser de la base de la couche tampon sacrificielle, suivi d'une deuxième étape par une attaque chimique préférentielle de ladite couche tampon sacrificielle (appelé ELO) de sorte que l'ablation par laser affaiblit la liaison entre la sous-couche sacrificielle et le substrat de croissance avant l'attaque chimique, pour accélérer la subséquente dissolution de la sous-couche et le décollage de la(les) sur-couche(s) épitaxiée(s) du substrat de croissance sans endommager la face arrière de la couche épitaxiée.

2. Procédé pour décoller une sur-couche ou un empilement de sur-couches épitaxiées d'un substrat de croissance recouverte d'une couche tampon sacrificielle selon la revendication 1 **caractérisé en ce que** le substart de croissance est du saphir et que la fragilisation de la base de la couche sacrificielle par ablation laser est fait à travers la face arrière, la face sans dépôt, du substrat de croissance.

3. Procédé pour décoller une couche ou un empilement de couches épitaxiées d'un substrat de croissance recouvert d'une sous-couche tampon sacrificielle selon la revendication 2, **caractérisé en ce que**, suivant la nature de la couche tampon sacrificielle, le pré-ablation par laser peut être réalisée par accumulation de tirs laser couvrant l'entière surface du substrat de saphir, ou par le balayage d'un faisceau laser mis en forme de façon optique pour obtenir la géométrie adéquate et homogène nécessaire à l'ablation laser.

4. Procédé pour décoller une sur-couche ou un empilement de sur-couches épitaxiées d'un substrat de croissance recouvert d'une sous-couche tampon sacrificielle selon la revendication 3, **caractérisé en ce qu'**après la mise en forme optique d'un faisceau laser, l'ablation par laser est effectuée sous n'importe quelle angle d'incidence entre 0°(degré) et 90° (degré) perpendiculaire à la surface du substrat de croissance jusqu'à la transversale du substrat de croissance sur une tranche, en focalisant l'énergie sur la sous-couche tampon sacrificielle de sorte à fragiliser la base de la sous-couche sacrificielle.

5. Procédé pour décoller une sur-couche ou un empilement de sur-couches épitaxiées d'un substrat de croissance recouvert d'une couche tampon sacrificielle selon l'une des revendications1 à 4, **caractérisé en ce que** l'ablation par laser peut être associé à un mouvement circulaire et/ou transversal du substrat de croissance pour une plus grande homogénéité d'excitation sur des substrats de grands dimensions.

6. Procédé pour décoller une sur-couche ou un empilement de sur-couches épitaxiées d'un substrat de croissance recouverte d'une sous-couche tampon sacrificielle selon l'une des revendications précédentes dans lequel la sur-couche épitaxiée est du GaN ou du SiC ou du Ga203 , et dans lequel la sous-couche tampon sacrificielle est en ZnO, ou en CrN ou en SiO₂, l'épaisseur de ladite sous-couche tampon sacrificielle est comprise entre 0,5 nm et 100 micron.

7. Composant à semiconducteur comprenant une couche épitaxiée ou un empilement de couches épitaxiées de matériau semiconducteur tel que du GaN ou du Ga203 ou du SiC avec une surface lisse décollée de son substrat de saphir selon le procédé des revendications 1 à 6 **caractérisé en ce que** ladite couche(s) de matériau semiconducteur décollée étant transférée sur un substrat d'accueil conducteur.

8. Composant à semiconducteur selon la revendication 7 **caractérisé en ce que** ledit substrat d'accueil est tel qu'il ait un facteur de dissipation de chaleur le plus forte possible possédant des caractéristiques optiques, électriques et thermiques pour les dispositifs de l'électronique de puissance tel que le SiC ou un diamond ou un métal.

9. Composant à semiconducteur selon la revendication 7 et 8 dont il est utilisé dans l'électronique de puissance.

10. Composant à semiconducteur selon la revendication 7 et 8 dont il est utilisé dans des dispositifs tels que des diodes électroluminescentes ou des transistors.
